# EUROPEAN PATENT APPLICATION

(11) **EP 4 848 948 A1**
(43) Date of publication of application: **02.12.2026**
(21) Application number: 24920134.4
(22) Date of filing: 29.11.2024
(51) Int. Cl.: H10F 39/18, H04N 25/63, H04N 25/70, H04N 25/771

(54) **IMAGING DEVICE**

(30) Priority: 25.01.2024 JP 2024009155
(71) Applicant: Sony Semiconductor Solutions Corporation, Atsugi-shi, Kanagawa 243-0014 (JP)
(72) Inventor: NAKAMOTO, Yuta, Atsugi-shi, Kanagawa 243-0014 (JP)
(74) Representative: Müller Hoffmann & Partner
(86) International application number: PCT/JP2024/042390
(87) International publication number: WO 2025/158777

(57) **Abstract**

The present technology enables transfer of charge from a photoelectric conversion unit while eliminating a trade-off relationship with pinning of an insulating layer.

This imaging device includes a pixel isolated by a pixel isolation region, and the pixel includes: a photoelectric conversion unit; a transfer transistor configured to transfer charge accumulated in the photoelectric conversion unit to a floating diffusion; an amplification transistor configured to output a signal corresponding to a potential of the floating diffusion; a selection transistor configured to select the output of the amplification transistor; a reset transistor configured to reset the floating diffusion; an overflow control transistor capable of setting a path for charge overflowing from the photoelectric conversion unit; an element isolation region configured to isolate the transfer transistor from the amplification transistor, the selection transistor, and the reset transistor; and a P-type impurity diffusion layer configured to isolate the transfer transistor from the overflow control transistor.

## Description

### TECHNICAL FIELD

The present technology relates to an imaging device. More specifically, the present technology relates to an imaging device capable of setting a path for charge overflowing from a photoelectric conversion unit.

### BACKGROUND ART

Some imaging devices are provided with an overflow control transistor capable of setting a path for charge overflowing from a photoelectric conversion unit. For example, there is disclosed an imaging device in which an overflow control transistor that transfers charge overflowing from a photoelectric conversion unit is provided as a planar transistor on a surface of a semiconductor substrate (see, for example, Patent Document 1).

### CITATION LIST

### PATENT DOCUMENT

Patent Document 1: WO 2021/235101 A

### SUMMARY OF THE INVENTION

### PROBLEMS TO BE SOLVED BY THE INVENTION

However, in the conventional technology described above, since the transfer path for the charge overflowing from the photoelectric conversion unit is arranged below an insulating layer, there is a trade-off relationship with pinning of the insulating layer, which may lead to a decrease in dark current margin.

The present technology has been made in view of such circumstances, and it is therefore an object of the present technology to enable transfer of charge from a photoelectric conversion unit while eliminating a trade-off relationship with pinning of an insulating layer.

### SOLUTIONS TO PROBLEMS

The present technology has been made to solve the problems described above, and a first aspect thereof is an imaging device including: a pixel isolated by a pixel isolation region, in which the pixel includes: a photoelectric conversion unit; a transfer transistor configured to transfer charge accumulated in the photoelectric conversion unit to a floating diffusion; an amplification transistor configured to output a signal corresponding to a potential of the floating diffusion; a selection transistor configured to select the output of the amplification transistor; a reset transistor configured to reset the floating diffusion; an overflow control transistor capable of setting a path for charge overflowing from the photoelectric conversion unit; an element isolation region configured to isolate the transfer transistor from the amplification transistor, the selection transistor, and the reset transistor; and a P-type impurity diffusion layer configured to isolate the transfer transistor from the overflow control transistor. This allows the transfer transistor to be isolated from the overflow control transistor while avoiding interference between the charge transfer path from the overflow control transistor and the element isolation region.

Furthermore, in the first aspect, the element isolation region may isolate the amplification transistor, the selection transistor, the reset transistor, and the overflow control transistor from each other. This ensures sufficient breakdown voltage for the amplification transistor, the selection transistor, the reset transistor, and the overflow control transistor.

Furthermore, in the first aspect, the transfer transistor may be arranged in a central portion of the pixel, and the amplification transistor, the selection transistor, the reset transistor, and the overflow control transistor may be arranged in a peripheral portion of the pixel. This allows a charge transfer path from the transfer transistor to the floating diffusion to be set while avoiding interference with the element isolation region.

Furthermore, in the first aspect, the pixel may further include: a capacitor configured to accumulate the charge overflowing from the photoelectric conversion unit; and a pass transistor configured to set a path through which the charge accumulated in the capacitor is transferred to the floating diffusion, and the pass transistor may be arranged in a peripheral portion of the pixel. This allows a charge transfer path from the capacitor to the floating diffusion to be set while arranging the transfer transistor in the central portion of the pixel.

Furthermore, in the first aspect, a drain of the overflow control transistor may be connected to the capacitor. This allows charge overflowing from the photoelectric conversion unit to be transferred to the capacitor via the overflow control transistor.

Furthermore, in the first aspect, the pixel may further include a switching transistor configured to switch conversion efficiency in the amplification transistor, and the switching transistor may be arranged in the peripheral portion of the pixel. This allows the conversion efficiency in the amplification transistor to be switched while arranging the transfer transistor in the central portion of the pixel.

Furthermore, in the first aspect, a drain of the overflow control transistor may be connected to a power supply potential. This allows charge overflowing from the photoelectric conversion unit to be discharged via the overflow control transistor.

Furthermore, in the first aspect, the amplification transistor, the selection transistor, the reset transistor, and the overflow control transistor may be in contact with the pixel isolation region. This allows the pixel transistors to be isolated while eliminating the need for an element isolation region between the pixel transistors arranged in the peripheral portion of the pixel and the pixel isolation region.

Furthermore, in the first aspect, the amplification transistor, the selection transistor, and the reset transistor may be in contact with the pixel isolation region, and the overflow control transistor may be spaced apart from the pixel isolation region. This allows pinning of the overflow control transistor to be achieved on the pixel isolation region side.

Furthermore, in the first aspect, the amplification transistor, the selection transistor, the reset transistor, and the overflow control transistor may be spaced apart from the pixel isolation region. This allows pinning of the pixel transistors arranged in the peripheral portion of the pixel on the pixel isolation region side.

Furthermore, in the first aspect, the pixel isolation region may be a rear deep trench isolation (RDTI). This allows the pixel to be isolated while arranging channel regions of the transistors on the pixel isolation region.

Furthermore, in the first aspect, the pixel isolation region may be a full-thickness front deep trench isolation (FFTI). This allows the pixel to be completely isolated in the depth direction.

### BRIEF DESCRIPTION OF DRAWINGS

Fig. 1 is a block diagram illustrating a configuration example of an imaging device according to a first embodiment.
Fig. 2 is a block diagram illustrating a configuration example of a solid-state imaging device according to the first embodiment.
Fig. 3 is a diagram illustrating a circuit configuration example of a pixel provided in the solid-state imaging device according to the first embodiment.
Fig. 4 is a plan view illustrating a layout example of the pixel according to the first embodiment.
Fig. 5 is a cross-sectional view illustrating a configuration example of the pixel according to the first embodiment.
Fig. 6 is a plan view illustrating a layout example of a pixel according to a second embodiment.
Fig. 7 is a cross-sectional view illustrating a configuration example of the pixel according to the second embodiment.
Fig. 8 is a plan view illustrating a layout example of a pixel according to a third embodiment.
Fig. 9 is a cross-sectional view illustrating a configuration example of the pixel according to the third embodiment.
Fig. 10 is a diagram illustrating a circuit configuration example of a pixel provided in a solid-state imaging device according to a fourth embodiment.
Fig. 11 is a plan view illustrating a layout example of the pixel according to the fourth embodiment.
Fig. 12 is a plan view illustrating a layout example of a pixel according to a fifth embodiment.
Fig. 13 is a plan view illustrating a layout example of a pixel according to a sixth embodiment.
Fig. 14 is a cross-sectional view illustrating a configuration example of a pixel according to a seventh embodiment.
Fig. 15 is a perspective view illustrating an example of a stacked solid-state imaging device according to an eighth embodiment.
Fig. 16 is a block diagram illustrating a schematic configuration example of a vehicle control system.
Fig. 17 is an explanatory diagram illustrating an example of an installation position of an imaging section.

### MODE FOR CARRYING OUT THE INVENTION

Modes for carrying out the present technology (hereinafter referred to as embodiments) will be described below. The description will be given in the following order.
1. First embodiment (an example in which, in a pixel provided with a lateral overflow integration capacitor (LOFIC), a transfer transistor is arranged in a central portion of the pixel, and the transfer transistor and an overflow control transistor are isolated from each other via an impurity diffusion layer)
2. Second embodiment (an example in which, in a pixel provided with a LOFIC, a transfer transistor is arranged in a central portion of the pixel, the transfer transistor and an overflow control transistor are isolated from each other via an impurity diffusion layer, and the overflow control transistor is arranged spaced apart from a pixel isolation region)
3. Third embodiment (an example in which, in a pixel provided with a LOFIC, a transfer transistor is arranged in a central portion of the pixel, the transfer transistor and an overflow control transistor are isolated from each other via an impurity diffusion layer, and pixel transistors other than the transfer transistor are arranged spaced apart from a pixel isolation region)
4. Fourth embodiment (an example in which, in a floating diffusion storage global shutter, a transfer transistor is arranged in a central portion of a pixel, and the transfer transistor and an overflow control transistor are isolated from each other via an impurity diffusion layer)
5. Fifth embodiment (an example in which, in a floating diffusion storage global shutter, a transfer transistor is arranged in a central portion of a pixel, the transfer transistor and an overflow control transistor are isolated from each other via an impurity diffusion layer, and the overflow control transistor is arranged spaced apart from a pixel isolation region)
6. Sixth embodiment (an example in which, in a floating diffusion storage global shutter, a transfer transistor is arranged in a central portion of a pixel, the transfer transistor and an overflow control transistor are isolated from each other via an impurity diffusion layer, and pixel transistors other than the transfer transistor are arranged spaced apart from a pixel isolation region)
7. Seventh embodiment (an example in which a rear deep trench isolation (RDTI) is provided in a pixel isolation region)
8. Eighth embodiment (an example in which a pixel array unit is stacked)
9. Application example to mobile body

### <1. First embodiment>

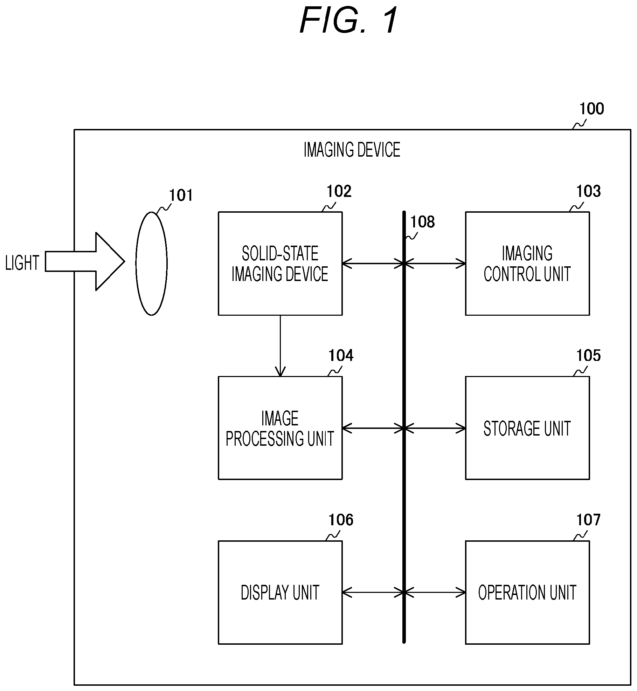

Fig. 1 is a block diagram illustrating a configuration example of an imaging device according to a first embodiment.

In Fig. 1, an imaging device 100 includes an optical system 101, a solid-state imaging device 102, an imaging control unit 103, an image processing unit 104, a storage unit 105, a display unit 106, and an operation unit 107. The imaging control unit 103, the image processing unit 104, the storage unit 105, the display unit 106, and the operation unit 107 are interconnected via a bus 108. Note that the imaging device 100 may be used as a stand-alone device, may be incorporated into a mobile terminal such as a smartphone, may be incorporated into an authentication device or a monitoring device, or may be incorporated into a vehicle or a drone.

The optical system 101 causes light from a subject to enter the solid-state imaging device 102, and forms an optical image on a light-receiving surface of the solid-state imaging device 102. The optical system 101 can include, for example, a focus lens, a zoom lens, a diaphragm, and the like. The optical system 101 may include a plurality of lenses such as a wide-angle lens, a standard lens, and a telephoto lens.

The solid-state imaging device 102 converts the optical image formed on the light-receiving surface into an electric signal for each pixel, digitizes the electric signal, and outputs the digitized electric signal. The solid-state imaging device 102 is, for example, a backside-illuminated complementary metal oxide semiconductor (CMOS) image sensor.

The imaging control unit 103 controls the imaging performed by the solid-state imaging device 102 on the basis of a command from the operation unit 107. At this time, the imaging control unit 103 can control the exposure time, the exposure amount, the imaging timing, and the like of the solid-state imaging device 102.

The image processing unit 104 performs image processing on the basis of the output from the solid-state imaging device 102. Examples of the image processing include gamma correction, white balance processing, sharpness processing, and gradation conversion processing. The image processing unit 104 may include a processor that performs processing on the basis of software.

The storage unit 105 stores captured images captured by the solid-state imaging device 102, and stores imaging parameters and the like of the solid-state imaging device 102. Furthermore, the storage unit 105 can store a program for causing the imaging device 100 to operate on the basis of software. The storage unit 105 may include a read only memory (ROM), a random access memory (RAM), and a memory card.

The display unit 106 displays a captured image and displays various types of information for supporting an imaging operation. The display unit 106 may be a liquid crystal display, an organic electro luminescence (EL) display, or a micro light-emitting diode (LED) display.

The operation unit 107 provides a user interface for operating the imaging device 100. The operation unit 107 may include, for example, a button, a dial, and a switch provided on the imaging device 100. The operation unit 107 may be implemented as a touch panel integrated with the display unit 106.

Note that, depending on the form of the imaging device 100, some of the functions described above may be omitted, or conversely, functions that are not disclosed may be further included.

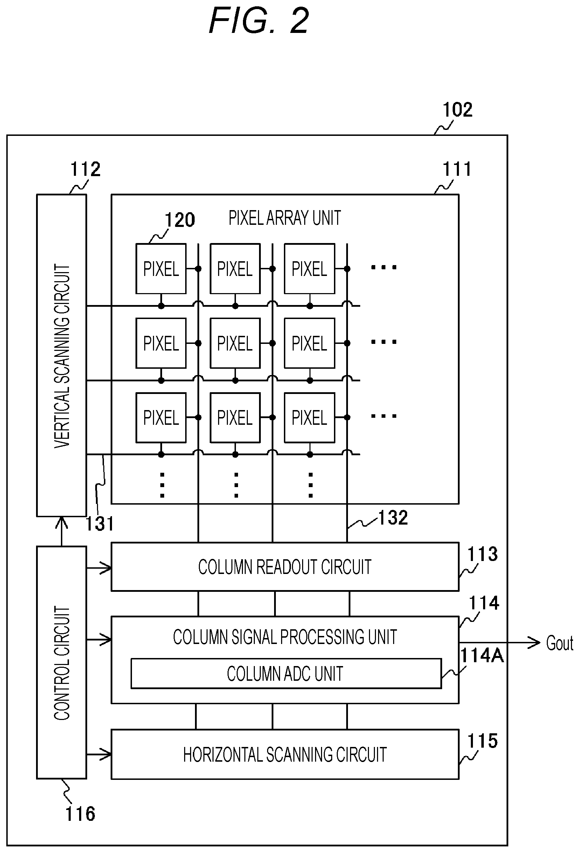

Fig. 2 is a block diagram illustrating a configuration example of the solid-state imaging device according to the first embodiment.

In Fig. 2, the solid-state imaging device 102 includes a pixel array unit 111, a vertical scanning circuit 112, a column readout circuit 113, a column signal processing unit 114, a horizontal scanning circuit 115, and a control circuit 116.

The pixel array unit 111 includes a plurality of pixels 120. The pixels 120 are arranged in a matrix along a row direction (also referred to as a horizontal direction) and a column direction (also referred to as a vertical direction). Each pixel 120 may support a lateral overflow integration capacitor (LOFIC) configuration or may support a floating diffusion storage global shutter operation. The LOFIC configuration allows each pixel 120 to include a capacitor that accumulates charge overflowing from a photodiode. Each pixel 120 may include a plurality of photodiodes having different sensitivities. Furthermore, each pixel 120 can form a source follower with the column readout circuit 113 during signal readout. Each pixel 120 is connected to a horizontal drive line 131 on a row-by-row basis, and is connected to a vertical signal line 132 on a column-by-column basis. When a signal is read out from each pixel 120, the horizontal drive line 131 drives the pixels 120 on a row-by-row basis. The vertical signal line 132 transmits, to the column signal processing unit 114 on a column-by-column basis, a potential based on a current flowing during signal readout from the pixels 120.

The pixels 120 may be arranged in a Bayer pattern or a quad Bayer pattern. The light received by each pixel 120 may be visible light, near infrared light (NIR), short wavelength infrared light (SWIR), ultraviolet light, X-rays, or the like.

The vertical scanning circuit 112 scans pixels 120 to be read out in the column direction. The vertical scanning circuit 112 may include a vertical register. The vertical scanning circuit 112 may include an address decoder or may include a driver that drives, on a row-by-row basis, the horizontal drive lines 131 selected via the address decoder.

The column readout circuit 113 can form a source follower with each pixel 120 during signal readout from the pixel 120. At this time, the column readout circuit 113 can change the potential of the vertical signal line 132 on the basis of the charge stored in the pixel 120.

The column signal processing unit 114 processes a signal transmitted from each pixel 120 in the column direction. For example, the column signal processing unit 114 can perform correlated double sampling (CDS) processing on the basis of the signal transmitted from each pixel 120 in the column direction. Furthermore, the column signal processing unit 114 can perform analog to digital (AD) conversion processing on the basis of the signal transmitted from each pixel 120 in the column direction and output an imaging signal Gout.

The column signal processing unit 114 includes a column ADC unit 114A. The column ADC unit 114A can perform AD conversion processing in parallel on a column-by-column basis. At this time, the column ADC unit 114A can perform, on a column-by-column basis, AD conversion on the basis of a comparison result between the pixel signal read out from the pixel 120 and a reference signal.

The horizontal scanning circuit 115 scans pixels 120 to be read out in the row direction. The horizontal scanning circuit 115 may include a horizontal register.

The control circuit 116 controls the vertical scanning circuit 112, the column readout circuit 113, the column signal processing unit 114, and the horizontal scanning circuit 115. For example, the control circuit 116 can control the scanning timing in the column direction, the scanning timing in the row direction, the operation timing of the column readout circuit 113, and the processing timing of the column signal processing unit 114. At this time, the control circuit 116 can cause the vertical scanning circuit 112, the column readout circuit 113, the column signal processing unit 114, and the horizontal scanning circuit 115 to cooperate so that the accumulation operation, the shutter operation, and the readout operation are performed on a row-by-row basis in each frame.

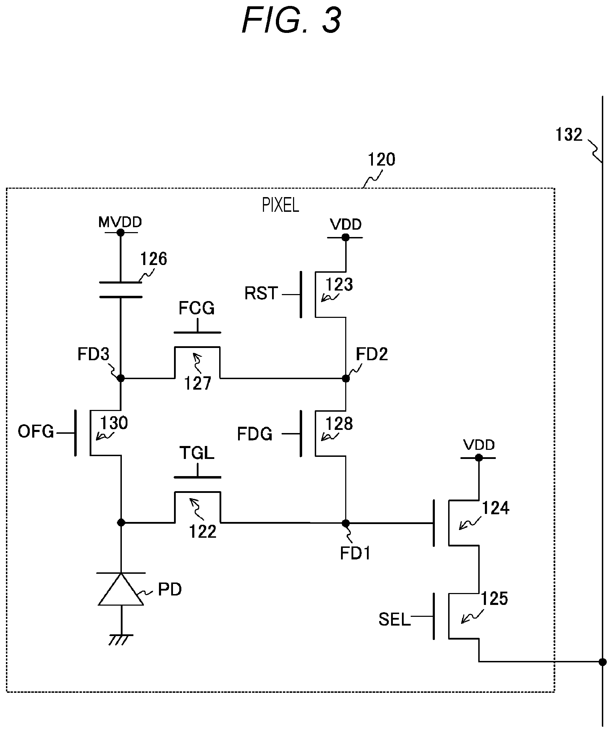

Fig. 3 is a diagram illustrating a circuit configuration example of the pixel provided in the solid-state imaging device according to the first embodiment. Note that Fig. 3 illustrates a configuration example of the pixel 120 supporting the LOFIC configuration.

In Fig. 3, the pixel 120 includes a photodiode PD, a transfer transistor 122, a reset transistor 123, an amplification transistor 124, a selection transistor 125, and floating diffusions FD1 to FD3. Moreover, the pixel 120 includes a capacitor 126, a pass transistor 127, a switching transistor 128, and an overflow control transistor 130. The transfer transistor 122, the reset transistor 123, the amplification transistor 124, the selection transistor 125, the pass transistor 127, the switching transistor 128, and the overflow control transistor 130 may be metal oxide semiconductor (MOS) transistors. A metal insulation metal (MIM) capacitor can be used as the capacitor 126. The capacitor 126 may be a three-dimensional MIM capacitor. The capacitor 126 may be a high-k capacitor. Note that the transfer transistor 122, the reset transistor 123, the amplification transistor 124, the selection transistor 125, the pass transistor 127, the switching transistor 128, and the overflow control transistor 130 are examples of the pixel transistor recited in the claims.

The photodiode PD performs photoelectric conversion and accumulates charge generated by the photoelectric conversion. The capacitor 126 accumulates charge overflowing from the photodiode PD. The capacitor 126 may be shielded from light. The capacitor 126 has one end connected to a control potential MVDD and the other end connected to a cathode of the photodiode PD via the overflow control transistor 130. The control potential MVDD can regulate a voltage applied to the capacitor 126 during the shutter period, the accumulation period, or the like. At this time, to reduce dark current, the capacitor 126 can be pulse-driven on the basis of the control potential MVDD.

The transfer transistor 122 transfers the charge accumulated in the photodiode PD to the floating diffusion FD1. The reset transistor 123 resets the floating diffusion FD1. The amplification transistor 124 outputs a signal corresponding to the potential of the floating diffusion FD1. The selection transistor 125 selects the output of the amplification transistor 124. The pass transistor 127 sets a path through which the charge accumulated in the capacitor 126 is transferred to the floating diffusion FD1. The switching transistor 128 switches conversion efficiency in the amplification transistor 124. The overflow control transistor 130 controls the overflow of the charge from the photodiode PD to the capacitor 126.

The transfer transistor 122 is connected between the floating diffusion FD1 and the cathode of the photodiode PD. The amplification transistor 124 and the selection transistor 125 are connected in series. The amplification transistor 124 has its drain connected to a power supply voltage VDD. The amplification transistor 124 has its gate connected to the floating diffusion FD1. The selection transistor 125 has its source connected to the vertical signal line 132.

The pass transistor 127 is connected between a connection point between the overflow control transistor 130 and the capacitor 126 and the switching transistor 128. The floating diffusion FD3 is formed at the connection point between the overflow control transistor 130 and the capacitor 126. The floating diffusion FD2 is formed at a connection point between the pass transistor 127 and the switching transistor 128. The switching transistor 128 is connected between the floating diffusions FD1 and FD2. The reset transistor 123 is connected between the floating diffusion FD2 and the power supply voltage VDD. The overflow control transistor 130 is connected between the photodiode PD and the capacitor 126.

A transfer signal TGL is applied to a gate of the transfer transistor 122. A reset signal RST is applied to a gate of the reset transistor 123. A selection signal SEL is applied to a gate of the selection transistor 125. A pass setting signal FCG is applied to a gate of the pass transistor 127. A switching signal FDG is applied to a gate of the switching transistor 128. An overflow control voltage OFG is applied to a gate of the overflow control transistor 130. The control potential MVDD is applied to the capacitor 126. The transfer signal TGL, the reset signal RST, the selection signal SEL, the pass setting signal FCG, the switching signal FDG, the overflow control voltage OFG, and the control potential MVDD can be transmitted to the pixel 120 via the horizontal drive line 131 illustrated in Fig. 2. The overflow control voltage OFG may be a fixed voltage.

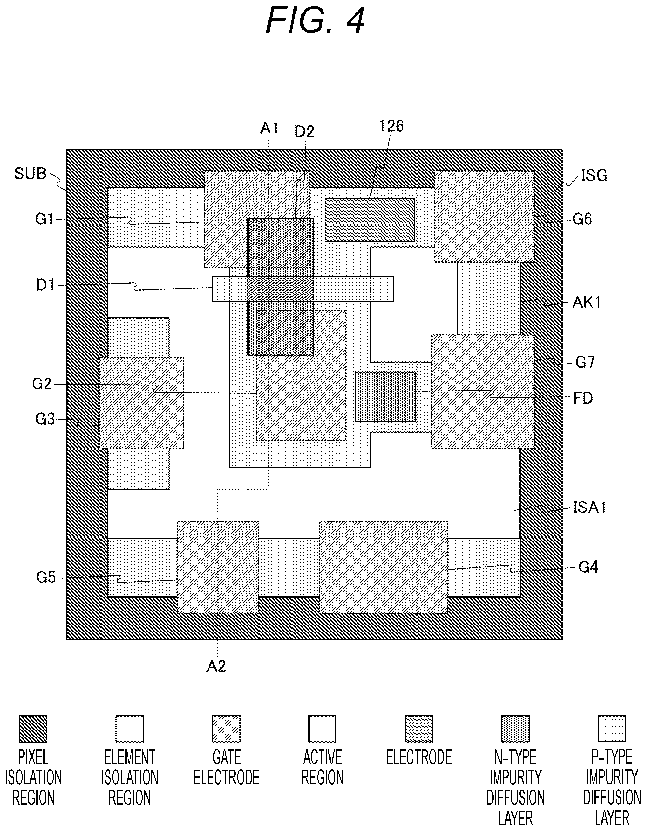

Fig. 4 is a plan view illustrating a layout configuration example of the pixel according to the first embodiment.

In Fig. 4, a semiconductor substrate SUB is isolated for each pixel 120 by a pixel isolation region ISG. An N-type semiconductor substrate can be used as the semiconductor substrate SUB. On a back surface side of the semiconductor substrate SUB, the photodiode PD is formed for each pixel 120. An active region AK1 is provided on a front surface side of the semiconductor substrate SUB, and the active region AK1 is isolated by an element isolation region ISA1. The element isolation region ISA1 may be a shallow trench isolation (STI). In the active region AK1, a channel region and an impurity diffusion layer are formed. A floating diffusion FD, a source layer, and a drain layer are formed in the impurity diffusion layer.

In the pixel 120, gate electrodes G1 to G7 are formed on the channel regions of the active regions AK1 with gate insulating films interposed therebetween. The gate electrode G1 can be used for the overflow control transistor 130. The gate electrode G2 can be used for the transfer transistor 122. The gate electrode G3 can be used for the reset transistor 123. The gate electrode G4 can be used for the amplification transistor 124. The gate electrode G5 can be used for the selection transistor 125. The gate electrode G6 can be used for the pass transistor 127. The gate electrode G7 can be used for the switching transistor 128. The floating diffusion FD is formed between the channel regions under the respective gate electrodes G2 and G7. The capacitor 126 is formed between the gate electrodes G1 and G6.

The transfer transistor 122 can be arranged in a central portion of the pixel 120. The reset transistor 123, the amplification transistor 124, the selection transistor 125, the pass transistor 127, the switching transistor 128, and the overflow control transistor 130 can be arranged in a peripheral portion of the pixel 120. Note that the central portion of the pixel 120 refers to a region inside the arrangement positions of the reset transistor 123, the amplification transistor 124, the selection transistor 125, the pass transistor 127, the switching transistor 128, and the overflow control transistor 130.

At this time, the reset transistor 123, the amplification transistor 124, the selection transistor 125, the pass transistor 127, the switching transistor 128, and the overflow control transistor 130 may be in contact with the pixel isolation region ISG. For example, on the pixel isolation region ISG side, the boundary of the active region AK1 of each of the reset transistor 123, the amplification transistor 124, the selection transistor 125, the pass transistor 127, the switching transistor 128, and the overflow control transistor 130 can be defined by the pixel isolation region ISG. At this time, parts of the peripheral portions of the gate electrodes G1 and G3 to G7 may be arranged on the pixel isolation region ISG.

The reset transistor 123, the amplification transistor 124, the selection transistor 125, the pass transistor 127, the switching transistor 128, and the overflow control transistor 130 can be isolated from each other via the element isolation region ISA1.

An impurity diffusion layer D2 is formed between the channel regions under the respective gate electrodes G1 and G2. The impurity diffusion layer D2 can be an N-type impurity diffusion layer. At this time, the impurity diffusion layer D2 can be higher in impurity concentration than the semiconductor substrate SUB. This makes it possible to optimize the potential gradient of the transfer path for the charge accumulated in the photodiode PD via the overflow control transistor 130. Therefore, even in a case where the overflow control transistor 130 is arranged in the peripheral portion of the pixel 120, the transfer efficiency for the charge accumulated in the photodiode PD via the overflow control transistor 130 can be improved. Note that the impurity diffusion layer D2 may be extended to the active regions AK1 under the respective gate electrodes G1 and G2.

Furthermore, an impurity diffusion layer D1 is formed between the channel regions under the respective gate electrodes G1 and G2. The impurity diffusion layer D1 can be arranged between the transfer transistor 122 and the overflow control transistor 130. The impurity diffusion layer D1 can be formed at a position shallower than the impurity diffusion layer D2. The impurity diffusion layer D1 can isolate the transfer transistor 122 and the overflow control transistor 130 from each other. The impurity diffusion layer D1 can be a P-type impurity diffusion layer. The impurity diffusion layer D1 can be higher in impurity concentration than a well D10. This makes it possible to form a potential barrier for isolating the transfer transistor 122 and the overflow control transistor 130.

Examples of the material of the semiconductor substrate SUB may include Si, InGaAs, InP, InSb, HgCdTe, and the like. As the material of the gate electrodes G1 to G7, for example, polycrystalline silicon can be used. As the material of the pixel isolation region ISG and the element isolation region ISA1, an insulator such as SiO₂ can be used. For example, a light-shielding material such as carbon black may be embedded in the pixel isolation region ISG to prevent color mixing and the like.

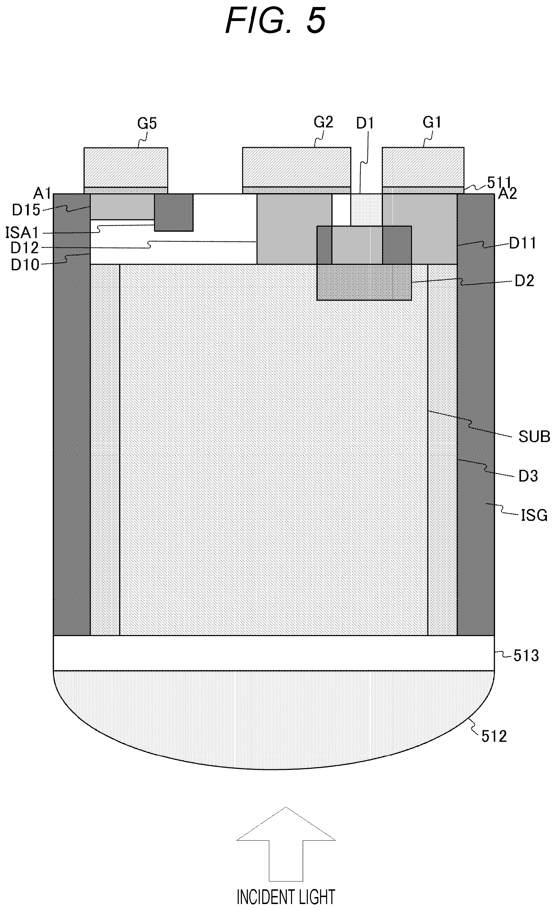

Fig. 5 is a cross-sectional view illustrating a configuration example of the pixel according to the first embodiment. Note that Fig. 5 illustrates a configuration example of a part of one pixel of a back-illuminated image sensor. Furthermore, Fig. 5 illustrates a cross-sectional view taken along line A1-A2 in Fig. 4.

In Fig. 5, the solid-state imaging device 102 includes the semiconductor substrate SUB. The light-receiving surface is provided on the back surface side of the semiconductor substrate SUB. At this time, the incident light can enter each pixel 120 from the back surface side of the semiconductor substrate SUB. On the back surface side of the semiconductor substrate SUB, a color filter 513 may be formed for each pixel 120, and an on-chip lens 512 may be formed for each pixel 120 on the color filter 513. As the materials of the color filter 513 and the on-chip lens 512, for example, an insulating film such as SiO₂, SiN, or SiCN, or a transparent resin such as acrylic or polycarbonate can be used. The color filter 513 may include a pigment. The color filter 513 may include an RGB filter, a complementary color filter, or a white filter.

The semiconductor substrate SUB is provided with the pixel isolation region ISG that isolates the pixel array unit 111 for each pixel 120. The pixel isolation region ISG may be an FFTI. At this time, the pixel isolation region ISG can extend through the semiconductor substrate SUB in a depth direction. The pixel isolation region ISG can be arranged at the boundary of the pixel 120.

Furthermore, the semiconductor substrate SUB is provided with the element isolation region ISA1 that isolates the active region AK1. As the element isolation region ISA1, the STI embedded in the semiconductor substrate SUB can be used. In the active region AK1, the well D10 forming a PN junction with the semiconductor substrate SUB can be formed. A P-well can be formed in the well D10. The gate electrodes G1, G2, and G5 are formed on the respective active regions AK1 with gate insulating films 511 interposed therebetween.

An impurity diffusion layer D11 may be formed under the gate electrode G1, an impurity diffusion layer D12 may be formed under the gate electrode G2, and an impurity diffusion layer D15 may be formed under the gate electrode G5. Each of the impurity diffusion layers D11, D12, and D15 can be an N-type impurity diffusion layer. At this time, the charge accumulated in the photodiode PD can be transferred from the transfer transistor 122 to the floating diffusion FD1 through a transfer path formed in the impurity diffusion layer D11. Furthermore, the charge accumulated in the photodiode PD can be transferred from the overflow control transistor 130 to the capacitor 126 through a transfer path formed in the impurity diffusion layers D2 and D11. Here, the depths of the impurity diffusion layers D11 and D12 can be set to be equal to or greater than the depth of the well D10. The depth of the impurity diffusion layer D15 can be less than the depth of the well D10. At this time, the impurity diffusion layers D11 and D12 can be formed to extend into the well D10. The impurity diffusion layer D15 can be spaced apart from the well D10. This makes it possible to form a transfer path for the charge accumulated in the photodiode PD for the transfer transistor 122 and the overflow control transistor 130. The selection transistor 125 can be spaced apart from the transfer path for the charge accumulated in the photodiode PD.

The impurity diffusion layer D2 is formed below and between the channel regions under the respective gate electrodes G1 and G2. The impurity diffusion layer D2 may extend across the junction surface between the semiconductor substrate SUB and the well D10. Furthermore, the impurity diffusion layer D1 is formed between the channel regions under the respective gate electrodes G1 and G2. The impurity diffusion layer D1 can be formed on the impurity diffusion layer D2. At this time, the impurity diffusion layer D1 can isolate the transfer transistor 122 and the overflow control transistor 130 from each other.

Furthermore, in the semiconductor substrate SUB, an impurity diffusion layer D3 is formed along the pixel isolation region ISG. The impurity diffusion layer D3 can be formed under the well D10. The impurity diffusion layer D3 can form a PN junction of the photodiode PD with the semiconductor substrate SUB. Furthermore, the impurity diffusion layer D3 can be used as a pinning layer at the interface of the pixel isolation region ISG. The impurity diffusion layer D3 can be a P-type impurity diffusion layer. The impurity diffusion layer D3 can be higher in impurity concentration than the impurity diffusion layer D1.

As described above, in the first embodiment, in the pixel 120 provided with the LOFIC, the transfer transistor 122 is arranged in the central portion of the pixel 120, and the reset transistor 123, the amplification transistor 124, the selection transistor 125, the pass transistor 127, the switching transistor 128, and the overflow control transistor 130 are arranged in the peripheral portion of the pixel 120. This makes it possible to set a charge transfer path from the transfer transistor 122 to the floating diffusion FD1 while avoiding a region under the element isolation region ISA1. It is therefore possible to eliminate a trade-off relationship between the setting of the charge transfer path from the transfer transistor 122 to the floating diffusion FD1 and the pinning of the element isolation region ISA1, thereby suppressing a decrease in the dark current margin.

Furthermore, the transfer transistor 122 and the overflow control transistor 130 are isolated from each other via the impurity diffusion layer D1. This makes it possible to isolate the transfer transistor 122 and the overflow control transistor 130 from each other while avoiding interference between the charge transfer path from the photodiode PD to the capacitor 126 via the overflow control transistor 130 and the element isolation region ISA1, thereby preventing a decrease in the dark current margin.

Moreover, the reset transistor 123, the amplification transistor 124, the selection transistor 125, the pass transistor 127, the switching transistor 128, and the overflow control transistor 130 are arranged in contact with the pixel isolation region ISG. This eliminates the need to form the element isolation region ISA1 between the pixel isolation region ISG and the transistors, namely, the reset transistor 123, the amplification transistor 124, the selection transistor 125, the pass transistor 127, the switching transistor 128, and the overflow control transistor 130. It is therefore possible to arrange the reset transistor 123, the amplification transistor 124, the selection transistor 125, the pass transistor 127, the switching transistor 128, and the overflow control transistor 130 in the peripheral portion of the pixel 120 while suppressing an increase in the pixel size.

### <2. Second embodiment>

In the first embodiment described above, in the pixel 120 provided with the LOFIC, the reset transistor 123, the amplification transistor 124, the selection transistor 125, the pass transistor 127, the switching transistor 128, and the overflow control transistor 130 are arranged in contact with the pixel isolation region ISG. In this second embodiment, in the pixel 120 provided with the LOFIC, the reset transistor 123, the amplification transistor 124, the selection transistor 125, the pass transistor 127, and the switching transistor 128 are arranged in contact with the pixel isolation region ISG, and the overflow control transistor 130 is arranged spaced apart from the pixel isolation region ISG.

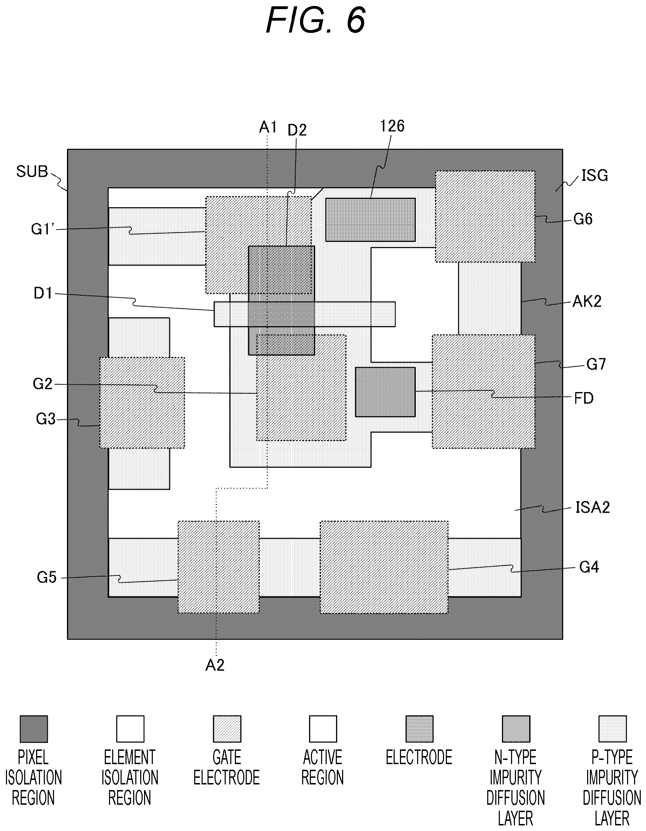

Fig. 6 is a plan view illustrating a layout example of the pixel according to the second embodiment.

In Fig. 6, the pixel includes an active region AK2, an element isolation region ISA2, and a gate electrode G1' in place of the active region AK1, the element isolation region ISA1, and the gate electrode G1 of the first embodiment described above. Other than the above, the pixel of the second embodiment is similar in configuration to the pixel of the first embodiment described above.

The active region AK2 is provided on the front surface side of the semiconductor substrate SUB and is isolated by the element isolation region ISA2. The gate electrode G1' can be used for the overflow control transistor 130. At this time, the active region AK2 and the gate electrode G1' of the overflow control transistor 130 are arranged spaced apart from the pixel isolation region ISG. Other than the above, the active region AK2, the element isolation region ISA2, and the gate electrode G1' are similar in configuration to the active region AK1, the element isolation region ISA1, and the gate electrode G1 of the first embodiment described above.

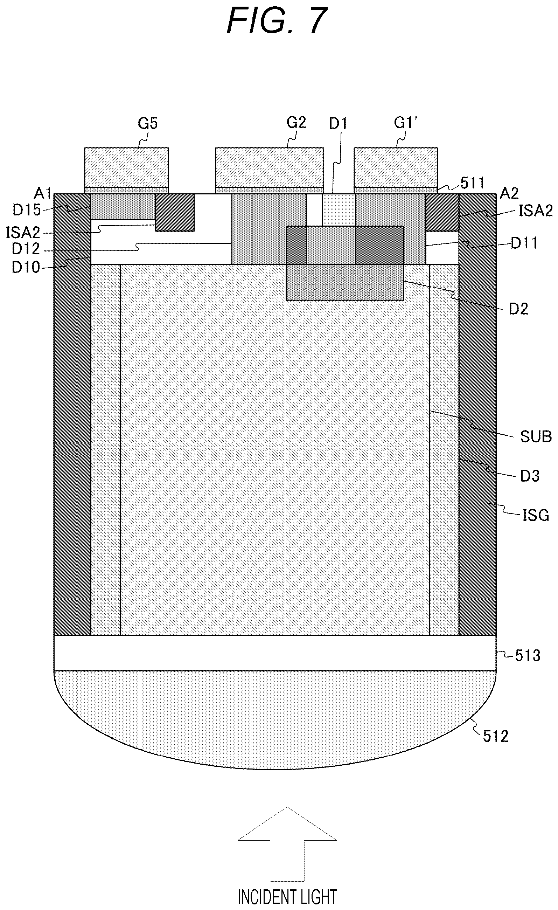

Fig. 7 is a cross-sectional view illustrating a configuration example of the pixel according to the second embodiment. Note that Fig. 7 illustrates a configuration example of a part of one pixel of a back-illuminated image sensor. Furthermore, Fig. 7 illustrates a cross-sectional view taken along line A1-A2 in Fig. 6.

In Fig. 7, the gate electrode G1' of the overflow control transistor 130 is arranged spaced apart from the pixel isolation region ISG. At this time, on the pixel isolation region ISG side, a peripheral portion of the gate electrode G1' can be arranged on the element isolation region ISA2.

As described above, in the second embodiment, in the pixel 120 provided with the LOFIC, the reset transistor 123, the amplification transistor 124, the selection transistor 125, the pass transistor 127, and the switching transistor 128 are arranged in contact with the pixel isolation region ISG, and the overflow control transistor 130 is arranged spaced apart from the pixel isolation region ISG. This makes it possible to achieve pinning of the overflow control transistor 130 on the pixel isolation region ISG side, and arrange the overflow control transistor 130 in the peripheral portion of the pixel 120 while suppressing a decrease in the dark current margin.

### <3. Third embodiment>

In the second embodiment described above, in the pixel 120 provided with the LOFIC, the reset transistor 123, the amplification transistor 124, the selection transistor 125, the pass transistor 127, and the switching transistor 128 are arranged in contact with the pixel isolation region ISG, and the overflow control transistor 130 is arranged spaced apart from the pixel isolation region ISG. In this third embodiment, in the pixel 120 provided with the LOFIC, the reset transistor 123, the amplification transistor 124, the selection transistor 125, the pass transistor 127, the switching transistor 128, and the overflow control transistor 130 are arranged spaced apart from the pixel isolation region ISG.

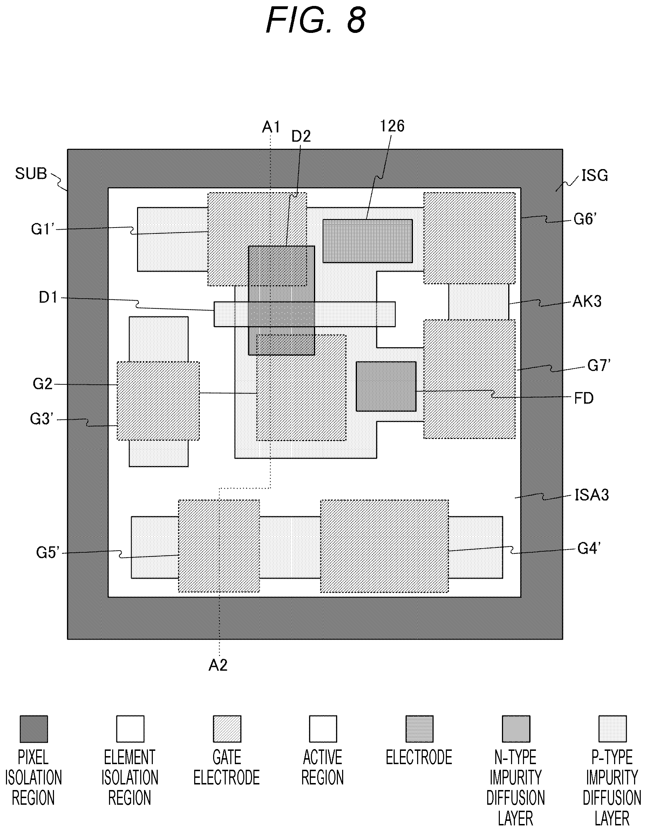

Fig. 8 is a plan view illustrating a layout example of the pixel according to the third embodiment.

In Fig. 8, the pixel includes an active region AK3, an element isolation region ISA3, and gate electrodes G3' to G7' in place of the active region AK2, the element isolation region ISA2, and the gate electrodes G3 to G7 of the second embodiment described above. Other than the above, the pixel of the third embodiment is similar in configuration to the pixel of the second embodiment described above.

The active region AK3 is provided on the front surface side of the semiconductor substrate SUB and is isolated by the element isolation region ISA3. The gate electrode G3' can be used for the reset transistor 123. The gate electrode G4' can be used for the amplification transistor 124. The gate electrode G5' can be used for the selection transistor 125. The gate electrode G6' can be used for the pass transistor 127. The gate electrode G7' can be used for the switching transistor 128. At this time, the active regions AK3 and the gate electrodes G3' to G7' of the reset transistor 123, the amplification transistor 124, the selection transistor 125, the pass transistor 127, and the switching transistor 128 are arranged spaced apart from the pixel isolation region ISG. Other than the above, the active region AK3, the element isolation region ISA3, and the gate electrodes G3' to G7' are similar in configuration to the active region AK2, the element isolation region ISA2, and the gate electrodes G3 to G7 of the second embodiment described above.

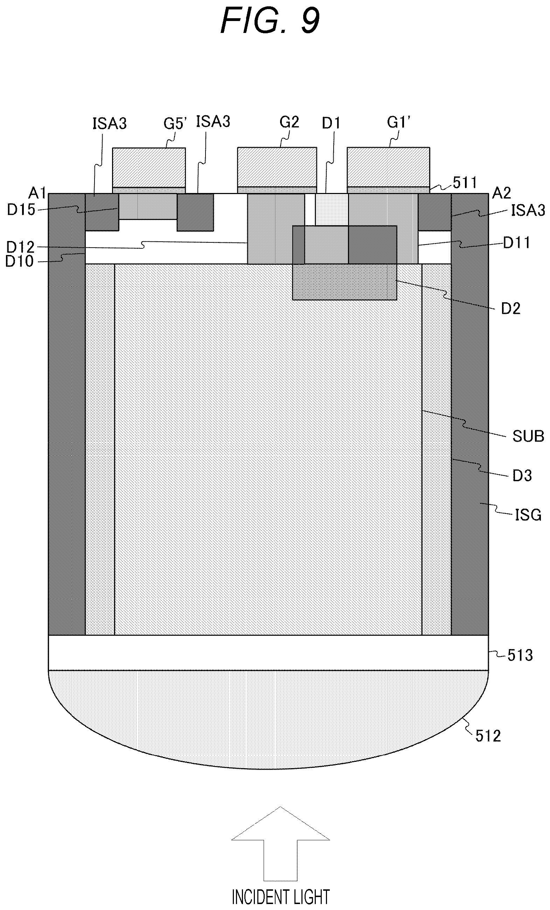

Fig. 9 is a cross-sectional view illustrating a configuration example of the pixel according to the third embodiment. Note that Fig. 9 illustrates a configuration example of a part of one pixel of a back-illuminated image sensor. Furthermore, Fig. 9 illustrates a cross-sectional view taken along line A1-A2 in Fig. 8.

In Fig. 9, the gate electrode G1' of the overflow control transistor 130 and the gate electrode G5' of the selection transistor 125 are arranged spaced apart from the pixel isolation region ISG. At this time, on the pixel isolation region ISG side, peripheral portions of the gate electrode G1' and G5' can be arranged on the element isolation region ISA3.

As described above, in the third embodiment, in the pixel 120 provided with the LOFIC, the reset transistor 123, the amplification transistor 124, the selection transistor 125, the pass transistor 127, the switching transistor 128, and the overflow control transistor 130 are arranged spaced apart from the pixel isolation region ISG. This makes it possible to achieve pinning of the reset transistor 123, the amplification transistor 124, the selection transistor 125, the pass transistor 127, the switching transistor 128, and the overflow control transistor 130 on the pixel isolation region ISG side. It is therefore possible to arrange the reset transistor 123, the amplification transistor 124, the selection transistor 125, the pass transistor 127, the switching transistor 128, and the overflow control transistor 130 in the peripheral portion of the pixel 120 while suppressing a decrease in the dark current margin.

### <4. Fourth embodiment>

As described above, in the first embodiment, in the pixel 120 provided with the LOFIC, the transfer transistor 122 is arranged in the central portion of the pixel 120, and the reset transistor 123, the amplification transistor 124, the selection transistor 125, the pass transistor 127, the switching transistor 128, and the overflow control transistor 130 are arranged in the peripheral portion of the pixel 120. In this fourth embodiment, in a floating diffusion storage global shutter, the transfer transistor 122 is arranged in the central portion of the pixel, and the reset transistor 123, the amplification transistor 124, the selection transistor 125, the switching transistor 128, and the overflow control transistor 130 are arranged in the peripheral portion of the pixel.

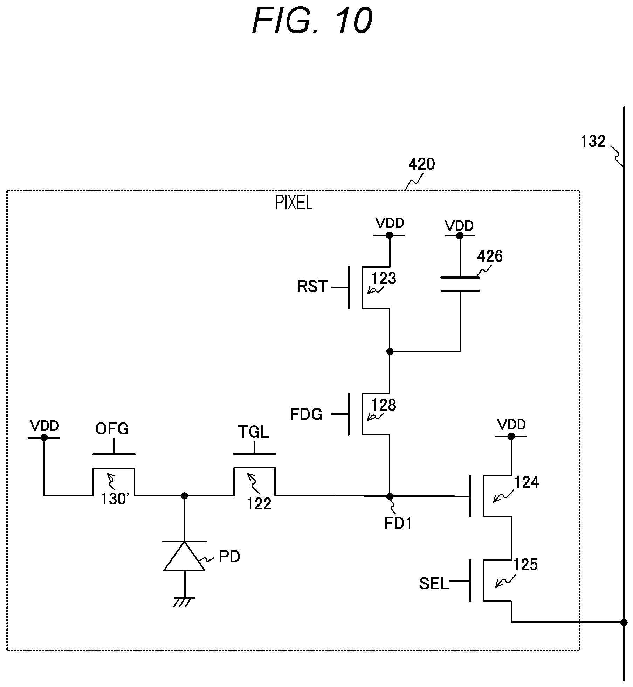

Fig. 10 is a diagram illustrating a circuit configuration example of a pixel provided in a solid-state imaging device according to the fourth embodiment. Note that Fig. 10 illustrates a configuration example of a pixel 420 supporting the floating diffusion storage global shutter.

In Fig. 10, the pixel 420 includes a capacitor 426 and an overflow control transistor 130' in place of the capacitor 126 and the overflow control transistor 130 of the first embodiment described above. Furthermore, the pixel 420 is obtained by removing the pass transistor 127 from the pixel 120 of the first embodiment described above. Other than the above, the pixel 420 of the fourth embodiment is similar in configuration to the pixel 120 of the first embodiment described above.

The overflow control transistor 130' is connected between the cathode of the photodiode PD and the power supply potential VDD. Here, the overflow control transistor 130' can discharge the charge accumulated in the photodiode PD to the power supply potential VDD during the shutter period. At this time, the pixel 420 can perform a floating diffusion storage global shutter operation. In the floating diffusion storage global shutter operation, the charge accumulated in the photodiode PD can be transferred to the floating diffusion FD1 simultaneously for all the pixels. Then, the global shutter operation can be performed by reading out the charge transferred to the floating diffusion FD1 on a row-by-row basis.

The capacitor 426 has one end connected to the power supply potential VDD and the other end connected to the floating diffusion FD1 via the switching transistor 128. Here, the capacitance of the capacitor 426 can be added to the floating diffusion FD1 or disconnected from the floating diffusion FD1 on the basis of the on/off state of the switching transistor 128, thereby allowing the conversion efficiency in the amplification transistor 124 to be switched. Note that the capacitor 426 need not be provided.

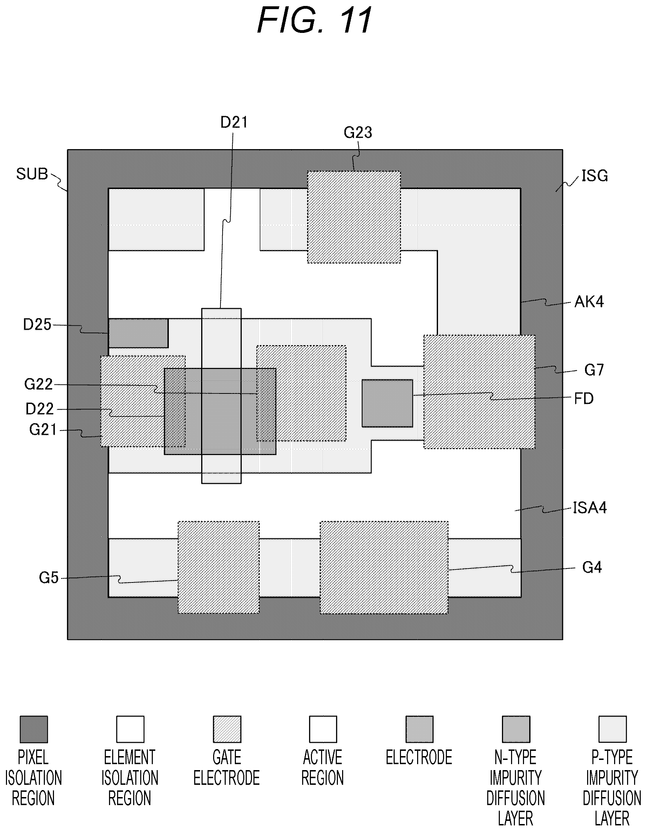

Fig. 11 is a plan view illustrating a layout example of the pixel according to the fourth embodiment.

In Fig. 11, the pixel 420 includes an active region AK4, an element isolation region ISA4, and gate electrodes G21 to G23 in place of the active region AK1, the element isolation region ISA1, and the gate electrodes G1 to G3 of the first embodiment described above. Furthermore, the pixel 420 is obtained by removing the gate electrode G6 from the pixel 120 of the first embodiment described above. Furthermore, the pixel 420 is obtained by adding an impurity diffusion layer D25 to the pixel 120 of the first embodiment described above. Other than the above, the pixel 420 of the fourth embodiment is similar in configuration to the pixel 120 of the first embodiment described above.

The active region AK4 is provided on the front surface side of the semiconductor substrate SUB and is isolated by the element isolation region ISA4. The gate electrode G21 can be used for the overflow control transistor 130'. The gate electrode G22 can be used for the transfer transistor 122. The gate electrode G23 can be used for the reset transistor 123. Here, the active region AK4 of the transfer transistor 122 is arranged in the central portion of the pixel 420. The active region AK4 of each of the reset transistor 123 and the overflow control transistor 130' is arranged in the peripheral portion of the pixel 420. At this time, the active region AK4 of each of the reset transistor 123 and the overflow control transistor 130' may be in contact with the pixel isolation region ISG. Parts of the peripheral portions of the gate electrodes G21 and G23 may be arranged on the pixel isolation region ISG. Other than the above, the active region AK4, the element isolation region ISA4, and the gate electrodes G21 to G23 are similar in configuration to the active region AK1, the element isolation region ISA1, and the gate electrodes G1 to G3 of the first embodiment described above.

The impurity diffusion layer D25 is formed in the active region AK4. The impurity diffusion layer D25 can be arranged adjacent to the channel region under the gate electrode G21. The power supply potential VDD can be applied to the impurity diffusion layer D25.

As described above, in the fourth embodiment, in the floating diffusion storage global shutter, the transfer transistor 122 is arranged in the central portion of the pixel, and the reset transistor 123, the amplification transistor 124, the selection transistor 125, the switching transistor 128, and the overflow control transistor 130' are arranged in the peripheral portion of the pixel. This makes it possible to eliminate a trade-off relationship between the setting of the charge transfer path from the transfer transistor 122 to the floating diffusion FD1 and the pinning of the element isolation region ISA1, thereby suppressing a decrease in the dark current margin.

### <5. Fifth embodiment>

In the fourth embodiment described above, in the floating diffusion storage global shutter, the transfer transistor 122 is arranged in the central portion of the pixel, and the reset transistor 123, the amplification transistor 124, the selection transistor 125, the switching transistor 128, and the overflow control transistor 130' are arranged in the peripheral portion of the pixel. In this fifth embodiment, in the floating diffusion storage global shutter, the reset transistor 123, the amplification transistor 124, the selection transistor 125, and the switching transistor 128 are arranged in contact with the pixel isolation region ISG, and the overflow control transistor 130' is arranged spaced apart from the pixel isolation region ISG.

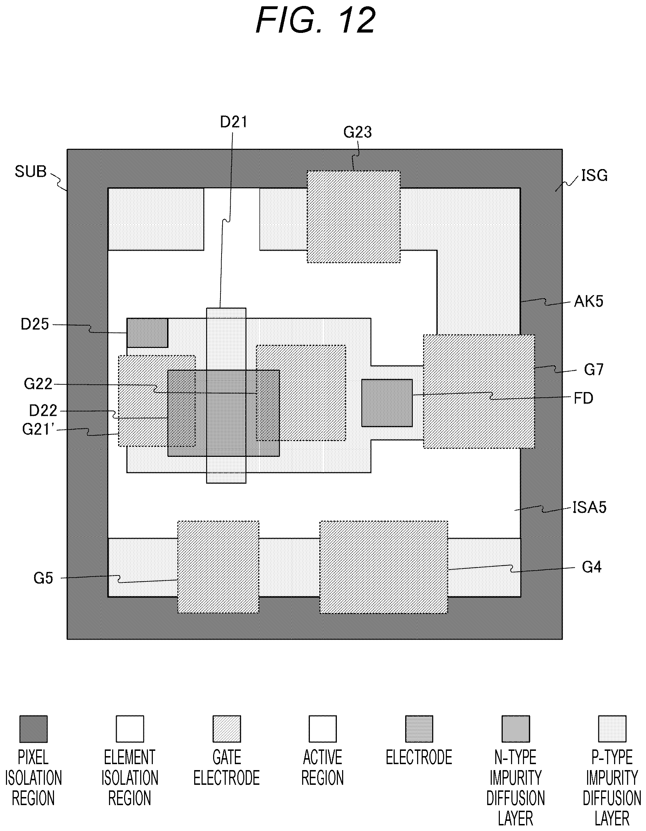

Fig. 12 is a plan view illustrating a layout example of the pixel according to the fifth embodiment.

In Fig. 12, the pixel includes an active region AK5, an element isolation region ISA5, and a gate electrode G21' in place of the active region AK4, the element isolation region ISA4, and the gate electrode G21 of the fourth embodiment described above. Other than the above, the pixel of the fifth embodiment is similar in configuration to the pixel of the fourth embodiment described above.

The active region AK5 is provided on the front surface side of the semiconductor substrate SUB and is isolated by the element isolation region ISA5. The gate electrode G21' can be used for the overflow control transistor 130'. At this time, the active region AK5 and the gate electrode G21' of the overflow control transistor 130' are arranged spaced apart from the pixel isolation region ISG. Other than the above, the active region AK5, the element isolation region ISA5, and the gate electrode G21' are similar in configuration to the active region AK4, the element isolation region ISA4, and the gate electrode G21 of the fourth embodiment described above.

As described above, in the fifth embodiment, in the floating diffusion storage global shutter, the reset transistor 123, the amplification transistor 124, the selection transistor 125, and the switching transistor 128 are arranged in contact with the pixel isolation region ISG, and the overflow control transistor 130' is arranged spaced apart from the pixel isolation region ISG. This makes it possible to achieve pinning of the overflow control transistor 130' on the pixel isolation region ISG side, and arrange the overflow control transistor 130' in the peripheral portion of the pixel 120 while suppressing a decrease in the dark current margin.

### <6. Sixth embodiment>

In the fifth embodiment described above, in the floating diffusion storage global shutter, the reset transistor 123, the amplification transistor 124, the selection transistor 125, and the switching transistor 128 are arranged in contact with the pixel isolation region ISG, and the overflow control transistor 130 is arranged spaced apart from the pixel isolation region ISG. In this sixth embodiment, in the floating diffusion storage global shutter, the reset transistor 123, the amplification transistor 124, the selection transistor 125, and the switching transistor 128, and the overflow control transistor 130 are arranged spaced apart from the pixel isolation region ISG.

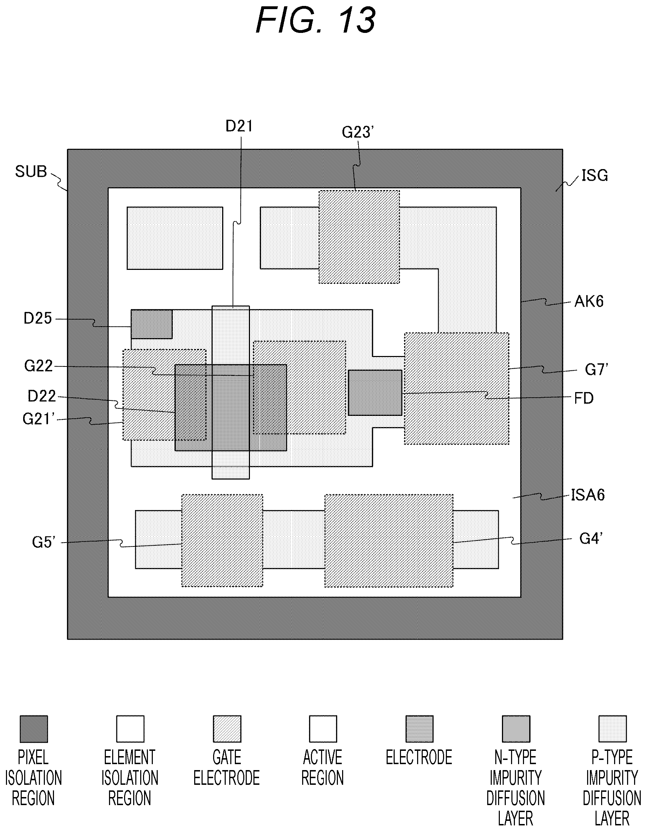

Fig. 13 is a plan view illustrating a layout example of the pixel according to the sixth embodiment.

In Fig. 13, the pixel includes an active region AK6, an element isolation region ISA6, and gate electrodes G23', G4', G5', and G7' in place of the active region AK5, the element isolation region ISA5, and the gate electrodes G23, G4, G5, and G7 of the fifth embodiment described above. Other than the above, the imaging device of the sixth embodiment is similar in configuration to the pixel of the fifth embodiment described above.

The active region AK6 is provided on the front surface side of the semiconductor substrate SUB and is isolated by the element isolation region ISA6. The gate electrode G23' can be used for the reset transistor 123. At this time, the active region AK6 and the gate electrode G23' of the reset transistor 123 are arranged spaced apart from the pixel isolation region ISG. Other than the above, the active region AK6, the element isolation region ISA6, and the gate electrode G23' are similar in configuration to the active region AK5, the element isolation region ISA5, and the gate electrode G23 of the fifth embodiment described above.

As described above, in the sixth embodiment, in the floating diffusion storage global shutter, the reset transistor 123, the amplification transistor 124, the selection transistor 125, and the switching transistor 128, and the overflow control transistor 130 are arranged spaced apart from the pixel isolation region ISG. This makes it possible to arrange the reset transistor 123, the amplification transistor 124, the selection transistor 125, the pass transistor 127, the switching transistor 128, and the overflow control transistor 130 in the peripheral portion of the pixel 120 while suppressing a decrease in the dark current margin.

### <7. Seventh embodiment>

In the first embodiment described above, the FFTI is formed in the pixel isolation region ISG. In this seventh embodiment, the RDTI is formed in the pixel isolation region.

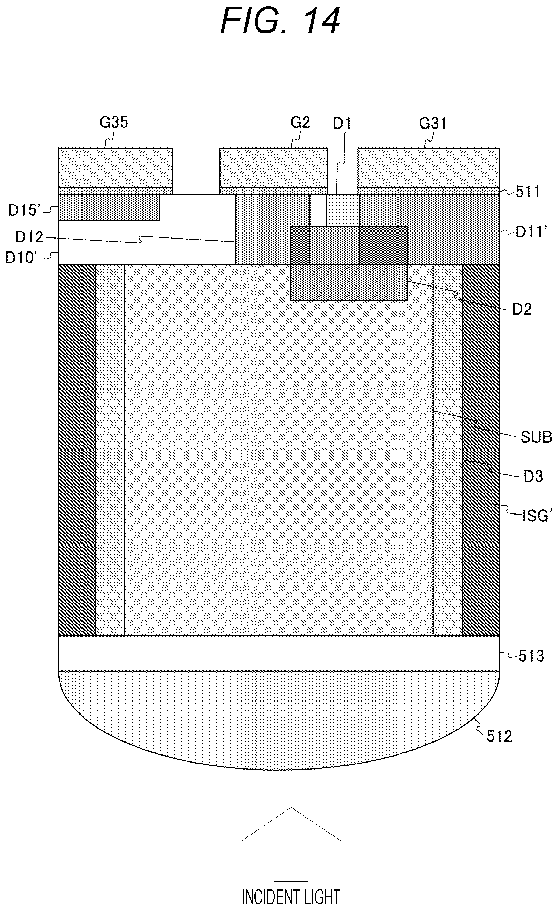

Fig. 14 is a cross-sectional view illustrating a configuration example of the pixel according to the seventh embodiment. Note that Fig. 14 illustrates a configuration example of a part of one pixel of a back-illuminated image sensor.

In Fig. 14, the pixel includes a pixel isolation region ISG', gate electrodes G31 and G35, and impurity diffusion layers D11' and D15' in place of the pixel isolation region ISG, the gate electrodes G1 and G5, and the impurity diffusion layers D11 and D15 of the first embodiment described above. Other than the above, the pixel of the seventh embodiment is similar in configuration to the pixel of the first embodiment described above.

The pixel isolation region ISG' is formed in the semiconductor substrate SUB. The RDTI can be formed in the pixel isolation region ISG'. The pixel isolation region ISG' can be embedded in the semiconductor substrate SUB from the back surface side of the semiconductor substrate SUB.

In the active region AK1, a well D10' forming a PN junction with the semiconductor substrate SUB is formed. At this time, the well D10' can be arranged on the pixel isolation region ISG' and the impurity diffusion layer D3. The gate electrodes G31, G2, and G35 are formed on the respective active regions AK1 with the gate insulating films 511 interposed therebetween. The impurity diffusion layer D11' may be formed under the gate electrode G31, and the impurity diffusion layer D15' may be formed under the gate electrode G35. At this time, the impurity diffusion layers D11' and D15' can be extended onto the pixel isolation region ISG'.

As described above, in the seventh embodiment, the RDTI is formed in the pixel isolation region ISG'. This makes it possible to isolate the pixel 120 while arranging the channel region of the pixel transistor on the pixel isolation region ISG'. It is therefore possible to increase the size of the pixel transistor without increasing the pixel size.

Note that, in the seventh embodiment described above, an example has been described in which the gate electrodes G31 and G35 are extended onto the pixel isolation region ISG'. The present embodiment is not necessarily limited to this example, and for example, the gate electrodes G3, G4, G6, and G7 of the first embodiment described above may be extended onto the pixel isolation region ISG'.

### <8. Eighth embodiment>

In the first embodiment described above, the transfer transistor 122 is arranged in the central portion of the pixel 120, and the reset transistor 123, the amplification transistor 124, the selection transistor 125, the pass transistor 127, the switching transistor 128, and the overflow control transistor 130 are arranged in the peripheral portion of the pixel 120. In this eighth embodiment, a semiconductor chip provided with a pixel array unit in which pixels are arranged in a matrix is stacked.

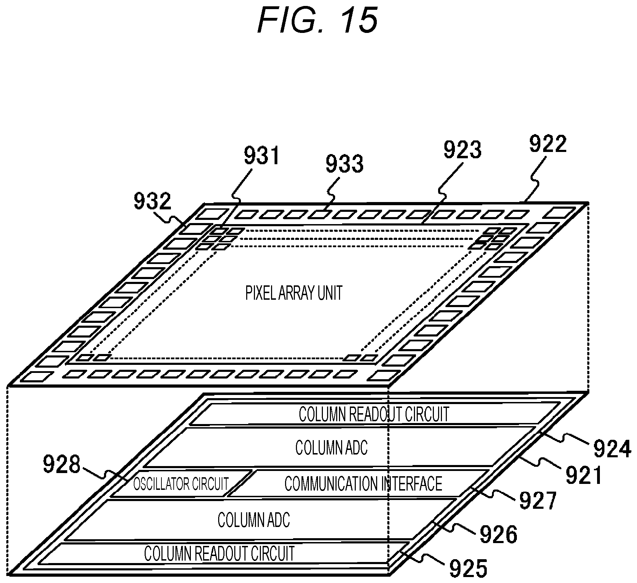

Fig. 15 is a perspective view illustrating an example of a stacked pixel array unit according to the eighth embodiment.

In Fig. 15, a solid-state imaging device includes semiconductor chips 921 and 922. The semiconductor chip 922 is stacked on the semiconductor chip 921.

A pixel array unit 923 is formed on the semiconductor chip 922. The pixel array unit 923 includes pixels 931 arranged in a matrix in the row direction and the column direction. The pixel 931 may be any pixel of the first to eighth embodiments described above. A pad electrode 932 and a via electrode 933 are formed around the pixel array unit 923. The via electrode 933 extends through the semiconductor chip 922 to electrically connect the semiconductor chips 921 and 922.

A peripheral circuit 924 is formed on the semiconductor chip 921. In the peripheral circuit 924, a column readout circuit 925, a column ADC 926, a communication interface 927, and an oscillator circuit 928 are formed. The column readout circuit 925 and the column ADC 926 may be formed so as to correspond to positions on both sides of the pixel array unit 923 in the column direction.

The semiconductor chips 921 and 922 may be directly bonded. For the direct bonding of the semiconductor chips 921 and 922, hybrid bonding can be used. At this time, the semiconductor chips 921 and 922 may be electrically connected on the basis of Cu-Cu connection. Examples of the material of a semiconductor substrate used for the semiconductor chips 921 and 922 may include Si, InGaAs, and InP.

As described above, in the eighth embodiment, the semiconductor chip 922 on which the pixel array unit 923 is formed is stacked on the semiconductor chip 921 on which the peripheral circuit 924 is formed. This makes it possible to increase sensitivity of the solid-state imaging device while suppressing an increase in mounting area of the semiconductor chip on which the solid-state imaging device is formed.

### <9. Application example to mobile body>

The technology according to the present disclosure (present technology) can be applied to various products. For example, the technology according to the present disclosure may be implemented as a device mounted on a mobile body of any kind, such as an automobile, an electric vehicle, a hybrid electric vehicle, a motorcycle, a bicycle, a personal mobility, an airplane, a drone, a vessel, or a robot.

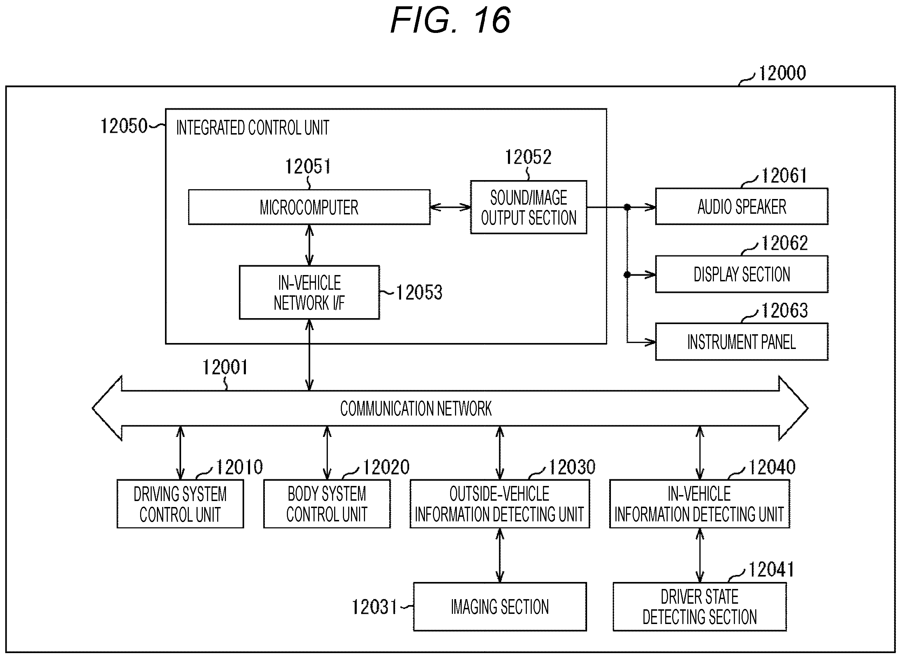

Fig. 16 is a block diagram illustrating a schematic configuration example of a vehicle control system as an example of a mobile body control system to which the technology according to the present disclosure can be applied.

The vehicle control system 12000 includes a plurality of electronic control units connected to each other via a communication network 12001. In the example illustrated in Fig. 16, the vehicle control system 12000 includes a driving system control unit 12010, a body system control unit 12020, an outside-vehicle information detecting unit 12030, an in-vehicle information detecting unit 12040, and an integrated control unit 12050. Furthermore, a microcomputer 12051, a sound/image output section 12052, and an in-vehicle network interface (I/F) 12053 are illustrated as functional components of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. Furthermore, the light received by the imaging section 12031 may be visible light, or may be invisible light such as infrared rays.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example illustrated in Fig. 16, an audio speaker 12061, a display section 12062, and an instrument panel 12063 are illustrated as the output device. The display section 12062 may, for example, include at least one of an on-board display and a head-up display.

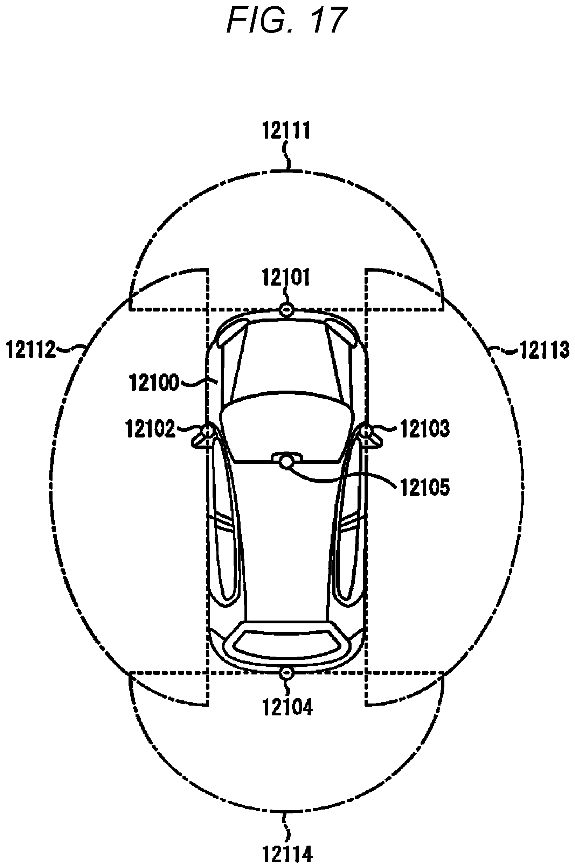

Fig. 17 is a diagram illustrating an example of the installation position of the imaging section 12031.

In Fig. 17, the imaging section 12031 includes imaging sections 12101, 12102, 12103, 12104, and 12105.

The imaging sections 12101, 12102, 12103, 12104, and 12105 are provided at positions on a vehicle 12100, such as a front nose, sideview mirrors, a rear bumper, a back door, and an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly images of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 17 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the above, an example has been described of the vehicle control system to which the technology according to the present disclosure can be applied. The technology according to the present disclosure is applicable to the imaging section 12031 among the components described above. Specifically, for example, the imaging devices of the first to eighth embodiments described above can be applied to the imaging section 12031. By applying the technology according to the present disclosure to the vehicle control system 12000, it is possible to improve image quality while suppressing a decrease in reliability of the imaging section 12031.

Note that the embodiments described above are merely examples for embodying the present technology, and the matters in the embodiments and the matters defining the invention in the claims have correspondence relationships. Similarly, the matters defining the invention in the claims and matters with the same names in the embodiments of the present technology have correspondence relationships. The present technology, however, is not limited to the embodiments, and can be embodied by applying various modifications to the embodiments without departing from the gist of the present technology. Furthermore, effects described herein are merely examples and are not intended to be limiting, and other effects may be provided.

Note that the present technology may also have the following configuration.
(1) An imaging device including:
   a pixel isolated by a pixel isolation region, in which
   the pixel includes:
      a photoelectric conversion unit;
      a transfer transistor configured to transfer charge accumulated in the photoelectric conversion unit to a floating diffusion;
      an amplification transistor configured to output a signal corresponding to a potential of the floating diffusion;
      a selection transistor configured to select the output of the amplification transistor;
      a reset transistor configured to reset the floating diffusion;
      an overflow control transistor capable of setting a path for charge overflowing from the photoelectric conversion unit;
      an element isolation region configured to isolate the transfer transistor from the amplification transistor, the selection transistor, and the reset transistor; and
      a P-type impurity diffusion layer configured to isolate the transfer transistor from the overflow control transistor.
(2) The imaging device according to the above (1), in which
   the element isolation region isolates the amplification transistor, the selection transistor, the reset transistor, and the overflow control transistor from each other.
(3) The imaging device according to the above (1) or (2), in which
   the transfer transistor is arranged in a central portion of the pixel, and
   the amplification transistor, the selection transistor, the reset transistor, and the overflow control transistor are arranged in a peripheral portion of the pixel.
(4) The imaging device according to any one of the above (1) to (3), in which
   the pixel further includes:
   a capacitor configured to accumulate the charge overflowing from the photoelectric conversion unit; and
   a pass transistor configured to set a path through which the charge accumulated in the capacitor is transferred to the floating diffusion, and
   the pass transistor is arranged in a peripheral portion of the pixel.
(5) The imaging device according to the above (4), in which
   a drain of the overflow control transistor is connected to the capacitor.
(6) The imaging device according to any one of the above (1) to (5), in which
   the pixel further includes a switching transistor configured to switch conversion efficiency in the amplification transistor, and
   the switching transistor is arranged in the peripheral portion of the pixel.
(7) The imaging device according to any one of the above (1) to (3), in which
   a drain of the overflow control transistor is connected to a power supply potential.
(8) The imaging device according to any one of the above (1) to (7), in which
   the amplification transistor, the selection transistor, the reset transistor, and the overflow control transistor are in contact with the pixel isolation region.
(9) The imaging device according to any one of the above (1) to (7), in which
   the amplification transistor, the selection transistor, and the reset transistor are in contact with the pixel isolation region, and the overflow control transistor is spaced apart from the pixel isolation region.
(10) The imaging device according to any one of the above (1) to (7), in which
   the amplification transistor, the selection transistor, the reset transistor, and the overflow control transistor are spaced apart from the pixel isolation region.
(11) The imaging device according to any one of the above (1) to (10), in which
   the pixel isolation region includes a rear deep trench isolation (RDTI).
(12) The imaging device according to any one of the above (1) to (10), in which
   the pixel isolation region includes a full-thickness front deep trench isolation (FFTI).

### REFERENCE SIGNS LIST

- 100: Imaging device
- 101: Optical system
- 102: Solid-state imaging device
- 103: Imaging control unit
- 104: Image processing unit
- 105: Storage unit
- 106: Display unit
- 107: Operation unit
- 108: Bus
- 111: Pixel array unit
- 112: Vertical scanning circuit
- 113: Column readout circuit
- 114: Column signal processing unit
- 115: Horizontal scanning circuit
- 116: Control circuit
- 120: Pixel
- PD: Photodiode
- FD1: to FD3 Floating diffusion
- 122: Transfer transistor
- 123: Reset transistor
- 124: Amplification transistor
- 125: Selection transistor
- 126: Capacitor
- 127: Pass transistor
- 128: Switching transistor
- 131: Horizontal drive line
- 132: Vertical signal line
- SUB: Semiconductor substrate
- ISG: Pixel isolation region
- ISA1 to ISA6: Element isolation region
- G1 to G7: Gate electrode
- D1, D2: Impurity diffusion layer

## Claims

1. An imaging device comprising:
a pixel isolated by a pixel isolation region, wherein
the pixel includes:
a photoelectric conversion unit;
a transfer transistor configured to transfer charge accumulated in the photoelectric conversion unit to a floating diffusion;
an amplification transistor configured to output a signal corresponding to a potential of the floating diffusion;
a selection transistor configured to select the output of the amplification transistor;
a reset transistor configured to reset the floating diffusion;
an overflow control transistor capable of setting a path for charge overflowing from the photoelectric conversion unit;
an element isolation region configured to isolate the transfer transistor from the amplification transistor, the selection transistor, and the reset transistor; and
a P-type impurity diffusion layer configured to isolate the transfer transistor from the overflow control transistor.

2. The imaging device according to claim 1, wherein
the element isolation region isolates the amplification transistor, the selection transistor, the reset transistor, and the overflow control transistor from each other.

3. The imaging device according to claim 1, wherein
the transfer transistor is arranged in a central portion of the pixel, and
the amplification transistor, the selection transistor, the reset transistor, and the overflow control transistor are arranged in a peripheral portion of the pixel.

4. The imaging device according to claim 1, wherein
the pixel further includes:
a capacitor configured to accumulate the charge overflowing from the photoelectric conversion unit; and
a pass transistor configured to set a path through which the charge accumulated in the capacitor is transferred to the floating diffusion, and
the pass transistor is arranged in a peripheral portion of the pixel.

5. The imaging device according to claim 4, wherein
a drain of the overflow control transistor is connected to the capacitor.

6. The imaging device according to claim 3, wherein
the pixel further includes a switching transistor configured to switch conversion efficiency in the amplification transistor, and
the switching transistor is arranged in the peripheral portion of the pixel.

7. The imaging device according to claim 1, wherein
a drain of the overflow control transistor is connected to a power supply potential.

8. The imaging device according to claim 1, wherein
the amplification transistor, the selection transistor, the reset transistor, and the overflow control transistor are in contact with the pixel isolation region.

9. The imaging device according to claim 1, wherein
the amplification transistor, the selection transistor, and the reset transistor are in contact with the pixel isolation region, and the overflow control transistor is spaced apart from the pixel isolation region.

10. The imaging device according to claim 1, wherein
the amplification transistor, the selection transistor, the reset transistor, and the overflow control transistor are spaced apart from the pixel isolation region.

11. The imaging device according to claim 1, wherein
the pixel isolation region includes a rear deep trench isolation (RDTI).

12. The imaging device according to claim 1, wherein
the pixel isolation region includes a full-thickness front deep trench isolation (FFTI).
